# EUROPEAN PATENT APPLICATION

(11) **EP 2 384 644 A1**
(43) Date of publication of application: **09.11.2011**
(21) Application number: 10162291.8
(22) Date of filing: 07.05.2010
(51) Int. Cl.: A23C 9/13, A23C 9/137, A23C 9/152, A23F 5/24, B65D 51/00

(54) **Beverage product with stable dairy foam**

(71) Applicant: Nestec S.A., 1800 Vevey (CH)
(72) Inventor: Chanet, Benjamin, 14000 CAEN (FR); Moreau, Jean, 14340 MANERBE (FR); Serre, Jean-Emmanuel, 14000 LE MESNIL-EUDES (FR); Mancho, José, 27230 THIBERVILLE (FR)
(74) Representative: Rossand, Isabelle

(57) **Abstract**

The present invention relates to a beverage product comprising a container, a liquid and a dairy foam on top of the liquid covering its surface. The dairy foam comprises 90 to about 100 wt% milk and milk fat, 0-10 wt% sweetener, and from 0.1 to about 1.5 wt%, preferably from 0.1 to about 1.0 wt% of a stabilizer. According to the invention the dairy foam has been applied first to an inner wall of the container along the entire circumference of said container before filling up the complete surface of the liquid so that it sticks to said inner wall. The present invention also relates to a method for manufacturing such a beverage product.

## Description

The present invention relates to a stable beverage product comprising a durable and stable dairy foam on top of a liquid beverage and method of manufacture of said beverage product.

Beverages with a foamed topping are very popular particularly among younger consumers who enjoy consuming such products either with using a straw or a spoon, mixing the foamed topping with the liquid beverage before drinking it or consuming the foamed topping separately. Such trendy products comprise today hot and cold beverages such as freshly prepared cappuccinos, latte macchiatos and other frothy milk shakes and beverages, most of them prepared at home or out-of home just before consumption.

There are a number of mechanical ways and devices for creating foam usually from milk using air and/or steam. Such mechanically produced foams usually persist only for a very short time on top of a liquid beverage and tend to collapse quickly thereafter. They usually have a poor texture, particularly if the liquid beverage itself contains the same or similar composition than the foam topping, for example a milk shake with a milk topping.

Certain mechanical methods involve quite substantial machinery to produce for example pressurized, superheated steam to introduce and mix for example with milk and/or a coffee beverage to produce viscous foams which are then added on top of beverages such as for example coffee. The result are coffee beverages such as cappuccinos which have a nicely foamed topping which persists long enough for the beverage to be served directly after production to a consumer, for example in a coffee shop, and the foam topping then being appreciated by the consumer during consumption.

Foams may be made more stable by adding thickeners to increase for example viscosity, However, highly viscous foams generally have slimy textures and are not palatable for certain uses, as for example as a topping for a coffee beverage. Where viscosities are very high, the formulations behave more like gels and it becomes difficult to introduce for example air into the formulation to actually make a foam and to apply it as a topping to a beverage liquid.

Whipped cream-like foams can be prepared from heavy cream or other high fat liquids, and are relatively stable in cool environments. Such whipped cream can be used and applied as topping for a diverse range of beverage products. Thereafter, the whipped cream dissolves into the beverage liquid and does not persist for a very long time as topping for said beverage product. Nevertheless, the creamy foam usually persists long enough on a liquid product for a consumer to be served and to appreciate the product during consumption.

WO2008/018075 discloses a floating topping for beverages which can be commercialised independently of a beverage and floated on top of a beverage by a consumer or at the point-of-sale of the beverage product. The disclosed topping is immiscible with the beverage liquid for at least the first 10 minutes.

Many products such as foaming creamers have emerged in the market-place to fill the need of consumers and coffee shops to provide beverages with a foaming topping. As an example US2005/0276898 is cited herewith. Such creamers are usually provided in a ready-to-use form and readily disperse in a hot or cold beverage to provide a creamer flavour and white foam on top of a liquid beverage without the use of equipment or machinery. Hence, here again, the foam topping is produced at a point-of-sale or at home and persists long enough for serving and consumption of the product, However, this type of topping is not sufficiently stable to be used in a product which is prepared a long time before consumption and sold through retail.

US2007/0065555 discloses formulations of palatable dairy foams with enhanced stability. The formulations include milk, a surfactant, a polysaccharide and a polymer capable of interacting with the polysaccharide. The foams can be used on beverages for example in high turnover restaurants and convenience stores. The foam remains "substantially stable" on a beverage surface for several minutes, meaning "the foam maintains at least about 75% of its height after 5 minutes". Here again, the foaming topping is produced at a point-of-sale and persists long enough for serving and consumption of the product, but loses its volume and mixes with the liquid after several minutes.

None of the above described technologies offers a possibility to produce a beverage product not at the place and time of consumption, but to have a beverage product with a dairy foamed topping produced at another location, for example a factory, and having the product transported and distributed via different channels to consumers who then may consume the product at a place of purchase or at home.

Hence, there is a need to have a stable liquid beverage product with a dairy foam as a stable topping, which topping persists as such not just for minutes, but for days, preferably several days, on top of the liquid phrase of the product. Further, the topping should resist and not disintegrate upon movement and agitation of the product as occurs during transportation and handling in the distribution chain. This would make such a new beverage product available to consumers also via the classical distribution chain, i.e. produced in a factory, transported to and distributed in a distribution centre.

The object of the present invention is thus to provide a stable beverage product comprising a durable and stable dairy foam on top of the liquid phase of the beverage as well as a method of manufacture of said beverage product,

This object is achieved by the subject matter of the independent claims. The dependent claims further develop the idea of the present invention.

Accordingly, the present invention pertains to a stable beverage product comprising a container, a liquid and a dairy foam on top of the liquid covering its surface, wherein the dairy foam comprises 90 to about 100 wt% milk and milk fat, 0-10 wt% sweetener, and from 0.1 to about 1.5 wt%, preferably from 0.1 to about 1.0 wit% of a stabilizer, and wherein the dairy foam has been applied first to an inner wall of the container along the entire circumference of said container before filling up the complete surface of the liquid so that it sticks to said inner wall.

A further aspect of the invention is a method for the manufacture of a beverage product comprising the steps of: i) filling a liquid into a container; ii) preparing a dairy base comprising 90 to about 100 wt% milk and milk fat, 0-10 wt% sweetener, and from 0.1 to about 1.5 wt%, preferably from 0.1 to about 1.0 wt% of a stabilizer; iii) aerating the dairy base to result in a foam; and iv) applying said foam on top of the liquid into the container with a dosing nozzle which dosing angle first points to an inner wall of the container so that the foam sticks to the inner wall of said container along the entire circumference of the container, and thereafter covering the remaining surface of the liquid with the foam,

The inventors surprisingly found that by combining the use of the claimed composition of a dairy foam together with a specific technology of applying such a dairy foam onto the top of a liquid beverage by sticking the foam onto the inner side of a container first before completing the rest of the liquid surface, there is a strong synergistic effect which improves the stability and persistence of the dairy foam on top of the liquid. This now significantly prolongs the time the dairy foam resides on top of the beverage liquid without being dissolved or disintegrated. Hence it becomes possible to produce beverage products having a foam topping for example in a factory and to sell them thereafter through retail, instead of for example preparing such beverage products at a. coffee shop or at home immediately before consumption.

The beverage product of the invention is stable in the sense that the dairy foam topping persists in its general aspect on top of the liquid phase of the beverage over an extended period of time under normal conditions of product handling and transportation as it is experienced in the trade and distribution of consumable food products. Thus, the beverage product keeps its general appearance with at least a significant part of the dairy foam on the top of the liquid phase, i.e. not dissolved or disintegrated into the liquid, for at least 2 weeks, preferably 3 weeks and more preferably 4 weeks, i.e. 28 days, or longer.

The dairy foam is made by aerating a dairy base comprising 90 to about 100 wt% milk and milk fat, optionally a sweetener up to a concentration of about 10 wt% of the dairy base, and 0.1-1.5 wt% of a stabilizer. The milk and milk fat comprise the dairy component of the base and can be constituted by combining commercial ingredients such as full fat milk, skimmed milk, dairy cream, milk powder and water. The sweetener can be a natural sweetener such as sugar, for example sucrose, or an artificial sweetener or any combination thereof.

The dairy foam on top of the liquid phase is applied first to an inner wall of the container along the entire circumference so that the foam sticks to the inner wall. Such sticking to the container can be achieved by first applying the foam, for example via a nozzle, directly to the wall of said container before putting it into contact with the liquid and filling the rest of the liquid surface with the foam thereafter. Without being bound to the theory, it is believed by the inventors, that this observed sticking is the result of adsorption via intermolecular forces and interfacial tension phenomena between the foam and the container wall.

The advantage of this method is that the dairy foam is well attached to the inner wall of the container all along the interface between the liquid and the container. Hence, there is no possibility for the liquid upon movement or agitation, to detach the foam from the container wall or to get in-between the foam and the container. This greatly stabilises the persistence and durability of the foam atop the liquid phase.

The product can now be stored for several days without that the foamed topping dissolves itself in the liquid. Product trials have shown that such beverage products can be stored under refrigeration at 8°C for 28 days and longer without a significant change or loss of the surface topping of the product. Furthermore, agitation of the product as it occurs, for example during transport from a factory to a supermarket, does not destroy the surface topping neither. For short moments, cups with the beverage and topping produced by the method of the invention, can be even turned up-side-down, without damaging or modifying the general appearance of the product.

In order to test commercial viability of the observed stability of the beverage product, 160 cups of the product according to the invention were transported on a pallet in a refrigerated truck for over 1'000 km in a week. After this test, the appearance of the products was equivalent to the one before the departure. Hence, it is now possible to produce a beverage product with a dairy foamed topping off-site of consumption as for example in a factory, to transport such a product over many kilometres, if necessary, and to propose it for sale for example in a distribution centre or any other product out-let. The products can then be consumed at such point-of-sale by a consumer or taken for example home and consumed later.

The advantage of the present invention is to provide a new beverage product which is a multi-layer product with at least one liquid phase and one dairy foam layer, which is stable and durable for many days and which therefore can be commercialized for example via classical distribution channels or trade.

In a preferred embodiment of the invention, the container of the product is a cup, preferably a transparent or a translucent cup for example made out of a plastic material.

Thereby, the advantage is in the presentation of the product to the consumer. It can be very appealing to the consumer to see that the product he is buying and consuming is for example a bi-layered beverage product with for example a creamy white topping. Using different coloured liquid phases as for example for dairy drinks can create contrasts with the topping and may be attractive to consumers. A translucent cup is advantageously used for better conservation of a beverage product which is sensitive to light, as for example a fermented dairy beverage, without losing the benefit of the visual aspect of a bi-layered product.

In a further preferred embodiment, the container is composed of two distinct sections, wherein the section with the larger inner cross-section resides on top of a section with the narrower inner cross-section as to build a ledge around the circumference at the inner wall of the container.

Thereby, by filling the lower part section of the container with the liquid and thereafter applying the dairy foam according to the invention onto the upper section of said container, the foam does not only stick to the inner wall but also firmly sits on the ledge between the two sections within the container. This enhances the stability and durability of the dairy foam atop of the beverage liquid.

In a further preferred embodiment of the invention, the product comprises a stabilizer selected from the group consisting of carrageenan, xanthan gum, locust bean gum, glycerol lactopalmitate emulsifier, carboxy methyl cellulose emulsifier and gelatine, or any combination thereof. Thereby, carrageenan, xanthan gum and locust bean gum, or a combination thereof, are preferably used for beverages comprising a low-fat liquid such as for example coffee. For beverages containing a milk based liquid the use of gelatine in combination with a glycerol lactopalmitate emulsifier is a preferred combination. Preferably, the product of the present invention is a coffee, chocolate or dairy beverage. It may also be possible to combine the different liquids as for example to result in a milk-coffee or milk-chocolate beverage or to combine coffee with chocolate and/or milk.

In a still further preferred embodiment, the product of the present invention can be a fermented product where the liquid, the dairy foam or both, i.e. the liquid and the dairy foam, are fermented. Thereby, the liquid can be of a milk basis which is fermented similarly as to a yoghurt or yoghurt-like drink. Alternatively or in combination, the dairy foam can have been made of a fermented dairy base.

Such products, advantageously, to present new tastes among the range of such bi-layered commercial beverage products to consumers. Fermented products are usually perceived by consumers as fresh and natural. A further advantage is that it presents products with health beneficial properties as for example containing fermentative probiotic microorganisms in the liquid and/or in the dairy foam. Such products are very attractive to health conscious consumers.

According to a further preferred embodiment, the liquid has a fat content of less than 1 wt% and/or a calorie content of less than 75 kcal/100 ml of the liquid. This again is very attractive and advantageous for health conscious consumers, who want to reduce or limit their in-take of fat and calories without, however, giving up on enjoying a pleasurable and healthy drink.

According to a still further preferred embodiment, the liquid comprises an extract of fruits which for example can be combined with milk to result in a smoothy-like texture. Suitable fruit extracts are for example mango fruit, strawberry or apple extract, or a combination thereof. Extracts from other fruits and/or combinations can be considered as well.

This again allows to advantageously addressing many health conscious consumers who want to have a large variety of different well and fresh tasting drinks and at the same time want to profit from the health benefits provided by fruits in the daily diet such as their content of vitamins, minerals and fibres.

Another object of the present invention is a method for the manufacture of said beverage product. For the method of the invention, aeration of the dairy base is achieved for example by whipping or by injecting a gas such as CO₂, nitrogen or air. Preferably, however, aerating the dairy base is achieved by whipping said base.

A still further preferred embodiment of the present invention is in the step iv) of the method, wherein the foam is applied to the inner wall of the container along the entire circumference of the container as a result of a circular movement of the nozzle and the container with respect to each other. Such a solution is particularly suitable and efficient for sticking the foam to the inner wall of the container.

A still further aspect of the method pertaining to step vi) is that the circular movement is the result of the container rotating in respect to the nozzle. This facilitates the technical implementation of the circular movement and allows using existing machinery with such installations for rotating containers during the filling procedure.

The method of the invention further comprises a step of heating the dairy base to at least 90°C to 150°C for 15 sec to 6 min followed by a cooling step preferably to at least 6°C before the step of aerating said dairy base. In this way, certain ingredients of the dairy base as the proteins from the milk and the stabilizers can better mix and interact with each other, in order to provide the advantageous effect of the dairy base composition.

### Brief Description of the Drawings

Figure 1 shows the first phase of applying the dairy foam into a container on top of the liquid.
Figure 2 shows the final beverage product,

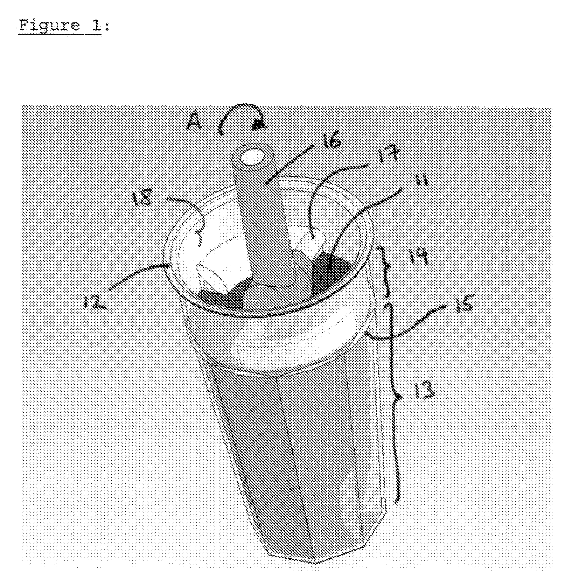

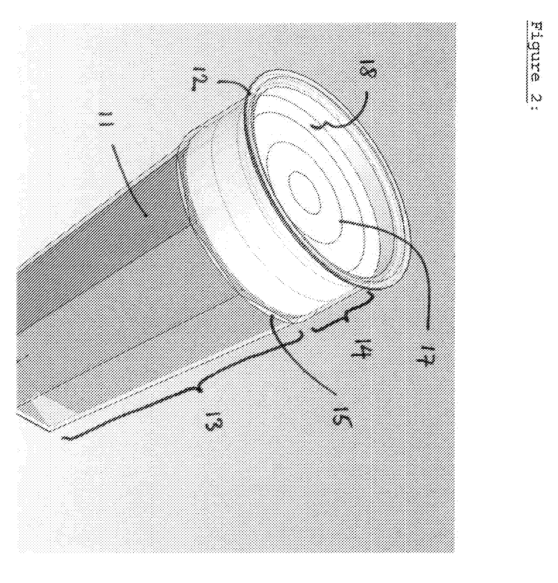

Figure 1. shows a liquid 11, which in a first step was filled into a container 12, The container 12 consists of a lower section 13 and an upper section 14, whereby the upper section 14 has a larger inner cross-section than the lower section 13, thus forming a ledge 15 around the circumference at the inner wall 18 of the container 12. The dairy foam 17 is applied onto the top of the liquid 11 with a nozzle 16, oriented in such a way as to first direct the dairy foam 17 towards the inner wall 18 of the container 12 in a circular movement A of the nozzle 16 along the entire circumference of the container 12. Thereafter, the rest of the liquid surface is covered with the dairy foam 17 to result into a final beverage product as shown in Figure 2. Thereby, the liquid 11 is now in the lower section 13 and the dairy foam 17 located in the upper section 14 of the container 12 and sits firmly on ledge 15 between the two sections of said container 12.

### Example 1

Chilled Coffee beverage
a) Preparation of the coffee liquid:
   Dried commercially available coffee extract, sucrose and milk proteins were mixed together and added to a liquid phase comprising milk, milk cream and water for standardization. After hydration, the mix was sterilized at high temperature for a short time and homogenized thereafter. The resulting coffee liquid was then cooled down to a temperature of 6°C, and filled into transparent plastic cups as shown in Figure 1.
b) Preparation of the dairy foam:
   A mix of dried stabilizers, 150 g carrageenan, 50 g xanthan gum and 8 g locust bean gum, was added to 100 litres of a standardized liquid milk comprising full fat milk, dairy cream and 6.5 wt% of sucrose. After hydration, the dairy base composition was sterilized at 145°C for 60 seconds. Thereafter, the composition was cooled down to 6°C.

The dairy mix was then whipped with a standard industrial aerator of the Aeromix type at a temperature of 8°C by injecting food grade nitrogen gas into the aerator.

Thereafter, the resulting dairy foam was applied as indicated in Figure 1 under ultra hygienic conditions into the transparent plastic cups containing the coffee liquid.

The cups were then stored under at 8°C for thirty days and thereafter tested.

The final product presented the following characteristics:

| | Swerving size (ml) | Weight (g) | TS (%) | Fat (g) | Added sugars (g) | Protein (g) | Ca (mg) | Energy (kcal) |
|---|---|---|---|---|---|---|---|---|
| Final product | 115 | 70 | 15 | 7 | 3 | 2 | 70 | 100 |
| Final product | 230 | 180 | 40 | 10 | 7 | 5 | 140 | 170 |

This product was then subjected to a transportation challenge test which consisted of transporting the final beverage products on a pallet in a truck for over 1'000 km during one week at 6°C. The general appearance of the two layered beverage products was not changed after that test in comparison to the appearance before starting the transportation test, i.e. the dairy foam remained stably on top of the liquid coffee.

### Example 2

Mango flavoured fermented dairy beverage
a) preparation of the fermented milk liquid:
   Milk was mixed with sucrose and pasteurized at 92°C during 6 minutes. Thereafter, the milk liquid was homogenized and cooled down to reach 41°C, before being inoculated with yoghurt strains for fermentation. Once pH 4,6 was reached, the fermentation was stopped and mango puree was added and mixed to the liquid. The liquid was cooled down to 6°C and filled into transparent plastic cups as shown in Figure 1.
b) Preparation of fermented dairy foam:
   500 g of glycerol lactopalmitate emulsifier and 500 g of dry gelatine were added to and mixed into 100 liters of liquid full fat milk comprising 5 wt% dairy cream and 5 wt% sucrose,

After hydration, the dairy base was pasteurized at 105°C during 2 minutes and then homogenized first at 200 bars and in a second step at 40 bars, The dairy base was then cooled down to reach 40°C, before being inoculated with yoghurt strains for fermentation, Once the pH of 4.6 was reached, the fermentation was stopped by cooling the dairy base to 6°C.

The dairy mix was then whipped with a standard industrial aerator of the Aeromix type at a temperature of 8°C by injecting food grade nitrogen gas into the aerator. Thereafter, the resulting dairy foam was applied as indicated in Figure 1 under ultra hygienic conditions into the transparent plastic cups containing the fermented mango-milk liquid.

The cups were then stored under at 8°C for thirty days.

The final produce presented the following characteristics;

| % | serving size (ml) | Weight (g) | TS (%) | Fat (g) | Added sugars (g) | Protein (g) | Ca (mg) | Energy (kcal) |
|---|---|---|---|---|---|---|---|---|
| Final product | 230 | 190 | 17 | 1 | 5 | 4 | 100 | 70 |

This product was successfully subjected to a transportation challenging test as described above under Example 1.

The general appearance of a two layered beverage products was not changed after that challenging test in comparison to the appearance before starting the transportation test, i.e. the dairy foam remained stably on top of the liquid mango flavoured milk,

### Example 3

### Comparative Example of a coffee beverage I

A coffee liquid was prepared and dosed into transparent plastic cups as in Example 1.

A dairy mix was prepared with the same standardized liquid milk comprising full fat milk, dairy cream and 6.5 wt% sucrose as in Example 1, however, without the addition of the stabilizers, carrageenan, xanthan gum and locust bean gum. The dairy mix was then sterilized, cooled and whipped in the same way as the dairy mix of Example 1.

The resulting dairy foam was applied as indicated in Figure 1 into transparent plastic cups containing the coffee liquid.

The cups were then kept at 8°C for several days and inspected on a daily basis. Thereby it was observed that for the beverage product samples not containing stabilizers in their dairy foam, the dairy foam started to shrink after 1 day (24 hours), i.e. to collapse and mix into the liquid. By the second day (48 hours), the dairy foam was not sticking to the inner wall of the cups anymore and what was left of the dairy foam was floating on top of the coffee liquid. By the third day, the foam was disintegrated entirely and there was no dairy foam left anymore on the top of the coffee liquid,

### Example 4

### Comparative Example of a coffee beverage II

A coffee liquid was prepared and dosed into transparent plastic cups as in Example 1.

A dairy mix was prepared with the same mix of dried stabilisers, standardized liquid milk comprising full fat milk, dairy cream and 6.5 wt% sucrose as in Example 1.

The dairy mix was then whipped with a standard industrial aerator of the Aeromix type at a temperature of 8°C by injecting food grade nitrogen gas into the aerator.

Thereafter, the resulting dairy foam was filled into the transparent plastic cups containing the coffee liquid in a conventional way by applying the foam with a dosing nozzle pointing first directly towards the centre of the liquid surface in the cup and covering the entire liquid surface thereafter,

The cups were then kept at 8°C for several days and inspected regularly. Thereby, it was observed that the dairy foam which had been applied in this conventional way directly to the centre of the liquid surface started already to visibly collapse after several minutes. After 1 day (24 hours) all of the dairy foam had disappeared and dissolved in the coffee liquid.

### Conclusions

The results of Experiment 1, 3 and 4 clearly indicated that there is a surprising synergistic effect when the specific composition of a dairy foam is combined with the specific way to apply that dairy foam onto a liquid surface in a cup. In Experiment 3 where the dairy foam was produced without the use of stabilisers and applied to the liquid surface in the specifically claimed way, the dairy foam did not last more than 3 days on top of that liquid in such a cup. Similarly, applying the dairy foam with stabilisers in the conventional way onto the liquid surface, i.e. applying it directly to the middle of the liquid surface, resulted in a dairy foam topping which started to collapse already after a few minutes and did not last more than 24 hours on the liquid surface. It is only when the two technical features, i.e. the composition of the dairy foam and the specific dosing application, that the dairy foam of the resulting beverage product persisted on top of the liquid surface for many days. In fact, the product looked unchanged with no visible loss of the dairy foam volume when kept for at least 28 days.

### Reference Numerals

- 11: liquid
- 12: container
- 13: lower auction of the container
- 14: upper section of the container
- 15: ledge
- 16: nozzle
- 17: dairy foam
- 18: inner wall of the container

## Claims

1. A beverage product comprising a container (12), a liquid (11) and a dairy foam (17) on top of the liquid (11) covering its surface, wherein the dairy foam (17) comprises 90 to about 100 wt% milk and milk fat, 0-10 wt% sweetener, and from 0.1 to about 1.5 wt%, preferably from 0.1 to about 1.0 wt% of a stabilizer, and wherein the dairy foam (17) has been applied first to an inner wall (18) of the container (12)along the entire circumference of said container (12) before filling up the complete surface of the liquid (11) so that it sticks to said inner wall (18).

2. The product of claim 1, wherein the container (12) is a transparent or translucent cup.

3. The product of claim 1. or 2, wherein the stabilizer is selected from the group consisting of carrageenan, xanthan gum, locust bean gum, glycerol lactopalmitate emulsifier, carboxy methyl cellulose emulsifier and gelatine, or any combination thereof.

4. The product of any of the preceding claims,
wherein the liquid (11) is a coffee, chocolate or dairy beverage, or a combination thereof.

5. The product of any of the preceding claims, wherein the liquid (11) is fermented.

6. The product of any of the preceding claims, wherein the dairy foam (17) is fermented.

7. The product of any of the preceding claims, wherein the liquid (11) has a fat content of less than. 1 wr% and/or a calorie content of less than 75 kcal/100 ml of the liquid (11),

8. The product of any of the preceding claims, wherein the liquid (11) comprises an extract of fruits such as from mango fruit, strawberry or apple, or a combination thereof.

9. A method for the manufacture of a beverage product comprising the steps of ;
i) Filling a liquid (11) into a container (12);
ii) Preparing a dairy base comprising 90 to about 100 wt% milk and milk fat, 0-10 wt% sweetener, and from 0.1 to about 1.5 wt%, preferably from 0.1 to about 1.0 wt% of a stabilizer ;
iii) Aerating the dairy base to result in a foam (17);
iv) Applying said foam (17) on top of the liquid (11) into the container (12) with a dosing nozzle (16) which dosing angle first points to an inner wall of the container (18) so that the foam (17) sticks to the inner wall of said container (18) along the entire circumference of the container (12), and thereafter covering the remaining surface of the liquid (11) with the foam (17).

10. The method of claim 9, wherein aerating the dairy base is achieved by whipping the dairy base.

11. The method of claim 9 or 10, wherein the foam (17) is applied to the inner wall of the container (18) along the entire circumference of the container (12) as a result of a circular movement of the nozzle (16) and the container (12) with respect to each other.

12. The method of claim 11, wherein the circular movement is the result of the container (12) rotating with respect to the nozzle (16).

13. The method of any of claims 9 - 12, further comprising a step of heating the dairy base to at least 90°C to 150°C for 15 sec to 6 min followed by a cooling step preferably to at least 6°C before the step of aerating said dairy base.
